# EUROPEAN PATENT SPECIFICATION

(11) **EP 0 247 172 B1**
(45) Date of publication and mention of the grant of the patent: **07.04.1993**
(21) Application number: 87900372.1
(22) Date of filing: 10.11.1986
(51) Int. Cl.: H03K 19/094

(54) **CMOS TO ECL INTERFACE CIRCUIT**
CMOS- ZU ECL-SCHNITTSTELLENSCHALTUNG
CIRCUIT D'INTERFACE CMOS-ECL

(30) Priority: 25.11.1985 US 801548
(43) Date of publication of application: 02.12.1987
(73) Proprietor: NCR INTERNATIONAL INC., Dayton, Ohio 45479 (US)
(72) Inventor: SANI, Mehdi, Hamidi, La Jolla, CA 92037 (US); TIPON, Donald, Greathouse, San Diego, CA 92129 (US)
(74) Representative: Robinson, Robert George
(86) International application number: PCT/US86/02396
(87) International publication number: WO 87/03435

(56) References cited:
- US-A- 3 708 689
- US-A- 4 217 502
- US-A- 4 275 313
- Patent abstract of Japan, vol.4, no.1, 8 January 1980, p.115E163 & JP-A-54-142060
- Patent abstract of Japan, vol.4, no.1, 8 January 1980, p.115E163 & JP-A-54-142059

## Description

### Technical Field

This invention relates to CMOS to ECL interface circuits, of the kind including input means adapted to receive CMOS logic level signals and output means adapted to provide ECL logic level signals.

### Background Art

U.S. Patent No. US-A-4,453,095 discloses a CMOS to ECL interface circuit for a five volt CMOS voltage swing, including a conventional CMOS inverter having an output coupled to the base electrode of an NPN transistor, which provides an ECL logic swing output at the emitter, which is coupled via termination resistor to a voltage supply source. The U.S. Patent also discloses a CMOS logic circuit for a two volt logic swing, including a conventional CMOS inverter having an output connected to a one input of a differential pair of bipolar transistor. The differential pair has an output connected to the base of a bipolar transistor whose emitter provides the desired ECL output.

From Patent Abstracts of Japan, vol. 4, No. 1, 8 January 1980, page 115, E163, abstract of JP-A-54 142 059, there is known an IGFET logic circuit wherein an additional n-channel IGFET, adapted to act as a voltage drop device, is inserted between the drains of p-channel and n-channel IGFETs to reduce logic amplitude and thereby achieve a saving in power consumption.

From Patent Abstracts of Japan, vol. 4, No. 1, 8 January 1980, page 115, E163, abstract of JP-A-54 142 060, there is known an IGFET logic circuit wherein an additional p-channel IGFET, acting as a voltage drop device, is inserted between the drains of p-channel and n-channel IGFETs to reduce logic amplitude and thereby achieve a saving in power consumption.

From US-A-3 708 689, there is known a buffer circuit for converting from TTL logic levels to MOS logic levels. The circuit utilizes four p-channel, low threshold transistors. Two of these transistors are connected between positive and negative supplies in the configuration of an MOS inverter circuit, the third transistor forms an output switch, connected to the buffer input, the inverter output and the buffer output terminals, and the fourth transistor is connected in a MOS load configuration between the drain of the third transistor and the negative supply. The third transistor utilizes the body effect to increase the threshold voltage thereof, so that the third transistor remains nonconductive even in the presence of noise or other spurious signals which may be inadvertently applied to the input terminal of the buffer.

From US-A-4 275 313, there is known an IGFET push-pull driver circuit which includes series-connected pull-up and pull-down transistors, and which may drive an ECL gate. In a CMOS implementation, the pull-up transistor is a p-channel device and the pull-down transistor is an n-channel device. Various arrangements for providing output current limitation are disclosed.

From US-A-4 217 502, there is known an output circuit in which a first IGFET of a first conductivity type is connected between a first potential supply terminal and an output terminal and has its substrate controlled by a third potential higher than the first potential of the first potential supply terminal acting in a "back gate bias" state. A second IGFET of a second conductivity type is connected between a second potential supply terminal having a second potential lower than the first potential and the output terminal and has its substrate electrode supplied with the second potential. A control circuit is further provided which receives an input signal and control signal and controls the output circuit to permit the latter to produce one of the first potential, second potential and high impedance state. The output circuit and control circuit are combined to provide a converter circuit for converting CMOS logic levels to TTL logic levels.

### Disclosure of the Invention

It is an object of the present invention to provide a CMOS to ECL interface circuit of the kind specified which is of simple construction, thereby minimizing propagation delays.

Therefore, according to the present invention, there is provided a CMOS to ECL interface circuit of the kind specified, characterized by first and second field effect transistors adapted to act as voltage drop devices being controlled in a complementary fashion by the CMOS logic level signals and having respective first and second source-drain paths connected in series between a single supply voltage source and a reference potential source, in that said second field effect transistor is connected to operate in a body effect mode, thereby increasing its threshold voltage, and in that the junction point between said first and second source-drain paths is connected to said output means, the arrangement being such that, in response to a first CMOS logic level input signal applied to said input means, said first field effect transistor, acting as a voltage drop device, is operative to cause said output means to provide a first ECL logic level output signal, and in response to a second CMOS logic level input signal applied to said input means said second field effect transistor, acting as a voltage drop device, is rendered operative in said body effect mode to provide a voltage drop greater than the voltage drop of said first field effect transistor thereby causing said output means to provide a second ECL logic level output signal.

It will be appreciated that a CMOS to ECL interface circuit according to the invention has the advantage that conversion of CMOS input levels which have a voltage swing of 3 volts is achieved with minimum propagation delay. Further advantages are that the interface circuit requires a minimum of integrated circuit area and uses relatively little power.

It should be understood that the present invention makes use of the body effect operative in the second transistor to achieve the desired output ECL voltage levels. As is known, the body effect, which is sometimes referred to as the back-gate bias, is effective for a transistor whose source electrode is ungrounded, to increase the threshold voltage of the transistor, that is, the gate voltage necessary to cause channel inversion.

### Brief Description of the Drawings

Three embodiments of the present invention will now be described by way of example with reference to the accompanying drawings, in which:-
Fig. 1 is a circuit diagram of one embodiment or the invention;
Fig. 2 is a circuit diagram of a second embodiment of the present invention; and
Fig. 3 is a circuit diagram of a third embodiment of the present invention.

### Best Mode for Carrying Out the Invention

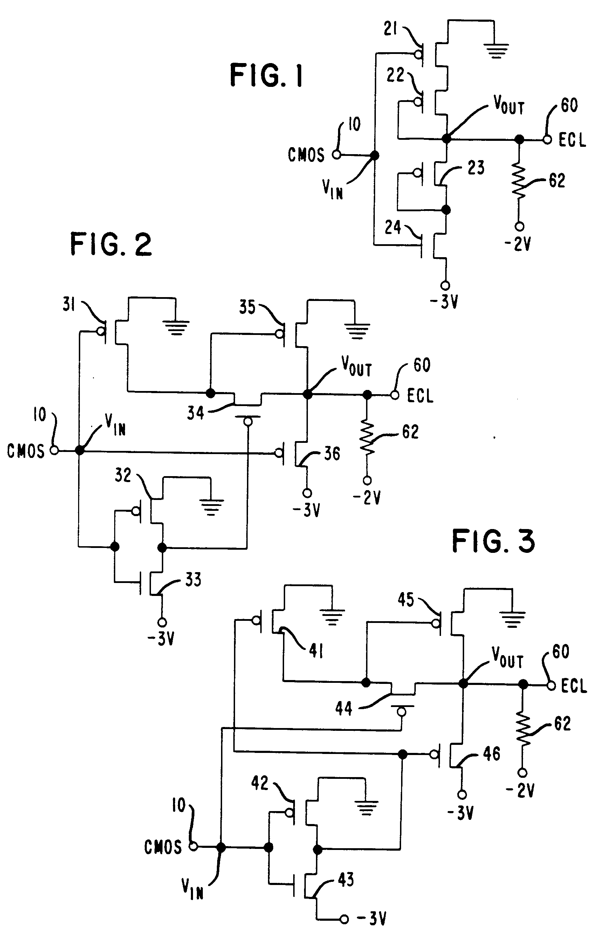

Referring to Fig. 1, four field effect transistors 21, 22, 23 and 24 are connected in series by their source and drain electrodes between a reference potential (ground) and a -3 volt DC power source. In the preferred embodiment, transistors 21, 22 and 23 are p-channel types and transistor 24 is of the n-channel type. The gate electrodes of transistors 21 and 24 are connected to an input terminal 10. The input terminal 10 is connectable to receive the logic level signal, Vᵢₙ, from a CMOS device, which signal has logic levels that range between -3 volts and 0 volts. The gate electrode of transistor 22 is connected to its drain electrode and to an output terminal 60. The gate electrode of transistor 23 is connected to its drain electrode. The output terminal 60 is connected to a -2 volt DC power source by a termination resistor 62. The output voltage level, Vₒᵤₜ, available on the output terminal 60 will range from -0.88 volts to -1.8 volts.

In the present circuit, the transistors 22 and 23 are operated in their saturation region which causes the transistors to act as diodes. The operation of the remainder of the circuit, for DC operation, is as follows: when the signal Vᵢₙ is -3 volts, the n-channel transistor 24 is turned off and the p-channel transistor 21 is turned on. The voltage on the output terminal 60 charges up to a voltage level of -0.88 volts which is a "HI" level input for ECL logic. When the input voltage Vᵢₙ equals 0 volts, the transistor 21 is turned off and transistor 24 is turned on thereby operating as a complementary switch. The voltage on the output terminal 60 then experiences a discharge to -1.8 volts which is a "LO" level input for ECL logic. This effect is caused somewhat by the body effect of transistor 23, which, as is known, increases the transistor threshold voltage when the source electrode is ungrounded. Thus, due to the body effect, the threshold voltage of the transistor 23 is greater than the threshold voltage of the transistor 22. The value of the termination resistor 62 may be 50 to 100 ohms.

Referring now to Fig. 2, wherein a second embodiment of the invention is disclosed, the input terminal 10 receives the CMOS logic level input signal and connects the signal to the gate electrode of the field effect transistors 31, 32, 33 and 36. The source electrode of field effect transistor 31 is connected to a reference potential, such as ground. The drain electrode of transistor 31 is connected to the source electrode of transistor 34 and to the gate electrode of transistor 35. The drain electrode of transistor 34 is connected to an output terminal 60 and to the drain and source electrodes of transistors 35 and 36, respectively. The source electrode of transistor 35 is connected to the reference potential. The drain electrode of transistor 36 is connected to a -3 volt DC power source. The source electrode of transistor 32 is also connected to the reference potential. The drain electrode of transistor 32 is connected to the drain electrode of transistor 33 and to the gate electrode of transistor 34. The source electrode of transistor 33 is connected to the -3 volt DC power source. Thus, the transistor pair 32, 33 is connected to operate as an inverter. The output terminal 60 is connected to a -2 volt DC power supply by means of a termination resistor 62.

In operation, when the voltage on the input terminal 10 equals 0 volts, transistors 31, 32 and 36 are turned off. Transistor 33 is turned on, thereby turning on transistors 34 and 35 which in turn pulls the output terminal voltage, Vₒᵤₜ, upwards to -0.88 volts. When the voltage Vᵢₙ, on the input terminal, goes to -3 volts, transistor 34 is turned off and transistor 31 is turned on turning off transistor 35, and transistor 36 is turned on, which in turn pulls down the voltage, Vₒᵤₜ, on the source electrode (output terminal 60) of transistor 36 to -1.8 volts in view of the body effect operative in the transistor 36. The transistors 35 and 36 operate in complementary fashion to alternately connect the output terminal to either the reference potential (ground) or to the CMOS compatible power supply (-3 volt DC) in response to the CMOS logic level signals coupled from the input terminal by field effect transistors 31-34.

The Fig. 2 circuit embodiment is noninverting, that is, as the input signal goes more positive, the output signal also goes more positive, and conversely, when the input signal goes more negative, the output signal will also go more negative. It is sometimes more preferable to have an inverting type circuit for interfacing two logic levels and such circuits are disclosed in the Fig. 1 and Fig. 3 embodiments.

Referring now to Fig. 3, the input terminal 10 is coupled to the gate electrode of transistors 42, 43 and 44. The transistor 42 has its source electrode connected to a reference potential, such as ground, and its drain electrode connected to the gate electrode of transistor 41, the gate electrode of transistor 46, and the drain electrode of transistor 43. The source electrode of transistor 43 is connected to a -3 volt DC power source. Thus, the transistor pair 42, 43 is connected to operate as an inverter. The source electrodes of transistors 41 and 45 are connected to a reference potential and the drain electrode of transistor 41 is connected to the source electrode of transistor 44 and the gate electrode of transistor 45. The drain electrode of transistor 44 is connected to the drain electrode of transistor 45 and to the source electrode of transistor 46. The drain and source electrodes of transistors 45 and 46 respectively are connected to the output terminal 60 which in turn is connected to a -2 volt DC power source, by means of a termination resistor 62. The drain electrode of transistor 46 is connected to the -3 volt DC power source.

In operation, when the voltage, Vᵢₙ, on the input terminal 10 goes to 0 volts, transistor 42 is turned off and transistor 43 is turned on. When transistor 43 is on, it turns on transistor 46 and turns on transistor 41. Transistor 44, being off, in turn causes transistor 45 to go off. This in turn, lowers the voltage, Vₒᵤₜ, on the output terminal 60 to -1.8 volts in view of the body effect operative in the transistor 46. When the voltage on the input terminal 10 goes to -3 volts, transistor 42 is turned on and transistor 43 is turned off. In addition, transistor 44 is turned on. With transistor 43 off, transistor 41 is turned off and transistor 45 is turned on. Transistor 46 tracks transistor 41 and is therefore turned off. With transistor 46 off and transistor 45 on, the voltage, Vₒᵤₜ, on the output terminal 60 rises to approximately -0.88 volts. It can thus be seen that for a 0 volt input there is a - 1.8 volt output and for a -3 volt input there is a relatively positive output of -0.88 volts. Therefore, the Fig. 3 circuit embodiment is an inverting circuit.

The circuit embodiments of the present invention provide a novel solution for interfacing CMOS logic level signals to ECL logic level signals while minimizing signal propagation delays and the use of semiconductor area.

## Claims

1. A CMOS to ECL interface circuit, including input means (10) adapted to receive CMOS logic level signals and output means (60,62) adapted to provide ECL logic level signals, characterized by first and second field effect transistors (22,23;35,36;45,46) adapted to act as voltage drop devices being controlled in a complementary fashion by the CMOS logic level signals and having respective first and second source-drain paths connected in series between a single supply voltage source and a reference potential source, in that said second field effect transistor (23,36,46) is connected to operate in a body effect mode, thereby increasing its threshold voltage, and in that the junction point (Vₒᵤₜ) between said first and second source-drain paths is connected to said output means, the arrangement being such that, in response to a first CMOS logic level input signal applied to said input means (10), said first field effect transistor (22,35,45), acting as a voltage drop device, is operative to cause said output means (60,62) to provide a first ECL logic level output signal, and in response to a second CMOS logic level input signal applied to said input means (10), said second field effect transistor (23,36,46), acting as a voltage drop device, is rendered operative in said body effect mode to provide a voltage drop greater than the voltage drop of said first field effect transistor (22,35,45) thereby causing said output means (60,62) to provide a second ECL logic level output signal.

2. A CMOS to ECL interface circuit according to claim 1, characterized in that said input means (10) is connected to the gate electrodes of third and fourth field effect transistors (21,24), having third and fourth source-drain paths, said third source-drain path being connected between said reference potential source and said first source-drain path, and said fourth source-drain path being connected between said second source-drain path and said supply voltage source.

3. A CMOS to ECL interface circuit according to claim 2, characterized in that said first, second and third field effect transistors (22, 23, 21) are of a first conductivity type and said fourth field effect transistor (24) is of a second conductivity type, in that said first field effect transistor (22) has its drain and gate electrodes connected to said junction point and its source electrode connected to the drain electrode of said third field effect transistor (21), in that said second field effect transistor (23) has its source electrode connected to said junction point and its drain and gate electrodes connected to the drain electrode of said fourth field effect transistor (24), in that said third field effect transistor (21) has its source electrode connected to said reference potential source and its gate electrode connected to said input means (10), in that said fourth field effect transistor (24) has its source electrode connected to said supply voltage source and its gate electrode connected to said input means (10), and in that said output means includes a resistor (62) connected between said junction point and a further supply voltage source.

4. A CMOS to ECL interface circuit according to claim 1, characterized by fifth and sixth field effect transistors (34, 31; 44, 41) having respective fifth and sixth source-drain paths connected in series between said junction point and said reference potential source, in that the gate electrode of said first transistor (35; 45) is connected to a further junction point, located between said fifth and sixth source-drain paths, and in that said input means (10), is connected to the gate electrodes of said second, fifth and sixth transistors (36, 34, 31; 46, 44, 41).

5. A CMOS to ECL interface circuit according to claim 4, characterized in that said input means (10) is coupled directly to the gate electrodes of said second and sixth transistors (36, 31) and, via inversion means (32, 33), to the gate electrode of said fifth transistor (34).

6. A CMOS to ECL interface circuit according to claim 4, characterized in that said input means (10) is coupled directly to the gate electrode of said fifth transistor (44), and, via inversion means (42, 43), to the gate electrodes of said second and sixth transistors (46, 41).

## Patentansprüche

1. CMOS-zu-ECL-Schnittstellenschaltung mit einer Eingangsvorrichtung (10), die geeignet ist, CMOS-Logikpegelsignale zu empfangen, und Ausgangsvorrichtungen (60, 62), die geeignet sind, ECL-Logikpegelsignale abzugeben, gekennzeichnet durch einen ersten und zweiten Feldeffekttransistor (22, 23; 35, 36; 45, 46), die geeignet sind, als Spannungsabfallvorrichtungen zu dienen, die in komplementärer Weise durch die CMOS-Logikpegelsignale gesteuert werden, und deren entsprechende erste und zweite Source-Drainstrecken in Bereiche zwischen eine einzige Spannungsversorgungsquelle und eine Bezugspotentialquelle geschaltet sind, daß der zweite Feldeffekttransistor (23, 36, 46) umgeschaltet ist, um in einem Körpereffektmode zu arbeiten, wodurch sich seine Schwellennetzspannung erhöht, und daß der Verbindungspunkt (Vₒᵤₜ) zwischen der ersten und zweiten Sourcedrainstrecke mit den Ausgangsvorrichtungen verbunden ist, wobei die Anordnung derart ist, daß unter Ansprechen auf ein an die Eingangsvorrichtung (10) angelegtes ertes CMOS-Logikpegeleingangssignal der erste Feldeffektransistor (22, 35, 45), der als eine Spannungsabfallvorrichtung wirkt, aktiv ist, um zu bewirken, daß die Ausgangsvorrichtungen (60, 62) ein erstes ECL-Logikpegelsignal abgeben, und unter Ansprechen auf ein an die Eingangsvorrichtung (10) angelegtes zweites CMOS-Logikpegeleingangssignal der zweite Feldeffekttransistor (23, 36, 46), der als eine Spannungsabfallvorrichtung wirkt, in seinem Körpereffektmode aktiviert wird, um einen Spannungsabfall zu bewirken, der größer ist als der Spannungsabfall des ersten Feldeffekttransistors (22, 35, 45), wodurch bewirkt wird, daß die Ausgangsvorrichtungen (60, 62) ein zweites ECL-Logikpegelausgangssignal abgeben.

2. Eine CMOS-zu-ECL-Schnittstellenschaltung nach Anspruch 1, dadurch gekennzeichnet, daß die Eingangsvorrichtung (10) mit den Gateelektroden eines dritten und vierten Feldeffekttransistors (21, 24) verbunden ist, die eine dritte und vierte Source-Drainstrecke aufweisen, wobei die dritte Source-Drainstrecke zwischen die Bezugspotentialquelle und die erste Source-Drainstrecke und die vierte Sourcedrainstrecke zwischen die zweite Source-Drainstrecke und die Versorgungsspannungsquelle geschaltet sind.

3. Eine CMOS-zu-ECL-Schnittstellenschaltung nach Anspruch 2, dadurch gekennzeichnet, daß der erste, zweite und dritte Feldeffekttransistor (22, 23, 21) von einem ersten Leitfähigkeitstyp sind und daß der vierte Feldeffekttransistor (24) von einem zweiten Leitfähigkeitstyp ist, daß der erste Feldeffektransistor (22) seine Drain- und Gateelektrode an den Verbindungspunkt angeschlossen hat und seine Sourceelektrode mit der Drainelektrode des dritten Feldeffektransistors (21) verbunden ist, daß der zweite Feldeffektransistor (23) seine Sourceelektrode mit dem Verbindungspunkt verbunden hat und seine Drain- und Gateelektrode mit der Drainelektrode des vierten Feldeffekttransistors (24) verbunden ist, daß der dritte Feldeffektransistor (21) seine Sourceelektrode mit der Bezugspotentialquelle verbunden hat und seine Gateelektrode mit der Eingangsvorrichtung (10) verbunden ist, daß der vierte Feldeffektransistor (24) seine Sourceelektrode an die Versorgungsspannungsquelle angeschlossen hat und seine Gateelektrode mit der Eingangsvorrichtung (10) verbunden ist und daß die Ausgangsvorrichtung einen einen Widerstand (62) aufweist, der zwischen den Verbindungspunkt und eine weitere Versorgungsspannungsquelle geschaltet ist.

4. Eine CMOS-zu-ECL-Schnittstellenschaltung nach Anspruch 1, gekennzeichnet durch einen fünften und sechsten Feldeffekttransistor (34, 31; 44, 41) mit einer fünften bzw. sechsten Source-Drainstrecke, die in Reihe zwischen den Verbindungspunkt und die Bezugspotentialquelle geschaltet sind, daß die Gateelektrode des ersten Transistors (35; 45) mit einem weiteren Verbindungspunkt verbunden ist, der zwischen der fünften und sechsten Source-Drainstrecke liegt und daß die Eingangsvorrichtung (10) mit den Gateelektroden des zweiten fünften und sechsten Transistors (36, 34, 31; 46, 44, 41) verbunden ist.

5. Eine CMOS-zu-ECL-Schnittstellenschaltung nach Anspruch 4, dadurch gekennzeichnet, daß die Eingangsvorrichtung (10) direkt mit den Gateelektroden des zweiten und sechsten Transistors (36, 31) und über eine Inversionsvorrichtung (32, 33) mit der Gateelektrode des fünften Transistors (34) verbunden ist.

6. Eine CMOS-zu-ECL-Schnittstellenschaltung nach Anspruch 4, dadurch gekennzeichnet, daß die Eingangsvorrichtung (10) mit der Gateelektrode des fünften Transistors (44) direkt und über eine Inversionsvorrichtung (42, 43) mit den Gateelektroden des zweiten und sechsten Transistors (46, 41) verbunden ist.

## Revendications

1. Circuit d'interface CMOS-ECL, comprenant des moyens d'entrée (10) destinés à recevoir des signaux de niveau logique CMOS et des moyens de sortie (60, 62) destinés à produire des signaux de niveau logique ECL, caractérisé par des premier et second transistors (22, 23 ; 35, 36 ; 45, 46) à effet de champ destinés à agir en tant que dispositifs de chute de tension commandés de façon complémentaire par les signaux de niveau logique CMOS et ayant des premier et second trajets source-drain respectifs connectés en série entre une source unique de tension d'alimentation et une source de potentiel de référence, en ce que ledit second transistor (23, 36, 46) à effet de champ est connecté de façon à travailler dans un mode à effet de corps, élevant ainsi sa tension de seuil, et en ce que le point de jonction (Vₒᵤₜ) entre lesdits premier et second trajets source-drain est connecté auxdits moyens de sortie, l'agencement étant tel que, en réponse à un premier signal d'entrée de niveau logique CMOS appliqué auxdits moyens d'entrée (10), ledit premier transistor (22, 35, 45) à effet de champ, agissant à la manière d'un dispositif de chute de tension, intervient pour amener lesdits moyens de sortie (60, 62) à produire un premier signal de sortie de niveau logique ECL et, en réponse à un second signal d'entrée de niveau logique CMOS appliqué auxdits moyens d'entrée (10), ledit second transistor (23, 36, 46) à effet de champ, agissant à la manière d'un dispositif de chute de tension, est amené à intervenir dans ledit mode à effet de champ pour produire une chute de tension supérieure à la chute de tension dudit premier transistor (22, 35, 45) à effet de champ, amenant ainsi lesdits moyens de sortie (60, 62) à produire un second signal de sortie de niveau logique ECL.

2. Circuit d'interface CMOS-ECL selon la revendication 1, caractérisé en ce que lesdits moyens d'entrée (10) sont connectés aux électrodes de grille de troisième et quatrième transistors (21, 24) à effet de champ, ayant des troisième et quatrième trajets source-drain, ledit troisième trajet source-drain étant connecté entre ladite source de potentiel de référence et ledit premier trajet source-drain, et ledit quatrième trajet source-drain étant connecté entre ledit second trajet source-drain et ladite source de tension d'alimentation.

3. Circuit d'interface CMOS-ECL selon la revendication 2, caractérisé en ce que lesdits premier, deuxième et troisième transistors (22, 23, 21) à effet de champ sont d'un premier type de conductivité et ledit quatrième transistor (24) à effet de champ est d'un second type de conductivité, en ce que ledit premier transistor (22) à effet de champ a ses électrodes de drain et de grille connectées audit point de jonction et son électrode de source connectée à l'électrode de drain dudit troisième transistor (21) à effet de champ, en ce que ledit deuxième transistor (23) à effet de champ a son électrode de source connectée audit point de jonction et ses électrodes de drain et de grille connectées à l'électrode de drain dudit quatrième transistor (24) à effet de champ, en ce que ledit troisième transistor (21) à effet de champ a son électrode de source connectée à ladite source de potentiel de référence et son électrode de grille connectée auxdits moyens d'entrée (10), en ce que ledit quatrième transistor (24) à effet de champ a son électrode de source connectée à ladite source de tension d'alimentation et son électrode de grille connectée auxdits moyens d'entrée (10), et en ce que lesdis moyens de sortie comprennent une résistance (62) connectée entre ledit point de jonction et une autre source de tension d'alimentation.

4. Circuit d'interface CMOS-ECL selon la revendication 1, caractérisé par des cinquième et sixième transistors (34, 31 ; 44, 41) à effet de champ ayant des cinquième et sixième trajets source-drain respectifs connectés en série entre ledit point de jonction et ladite source de potentiel de référence, en ce que l'électrode de grille dudit premier transistor (35 ; 45) est connectée à un autre point de jonction, situé entre lesdits cinquième et sixième trajets source-drain, et en ce que lesdits moyens d'entrée (10) sont connectés aux électrodes de grille desdits deuxième, cinquième et sixième transistors (36, 34, 31 ; 46, 44, 41).

5. Circuit d'interface CMOS-ECL selon la revendication 4, caractérisé en ce que lesdits moyens d'entrée (10) sont couplés directement aux électrodes de grille desdits deuxième et sixième transistors (36, 31) et, par l'intermédiaire de moyens d'inversion (32, 33), à l'électrode de grille dudit cinquième transistor (34).

6. Circuit d'interface CMOS-ECL selon la revendication 4, caractérisé en ce que lesdits moyens d'entrée (10) sont couplés directement à l'électrode de grille dudit cinquième transistor (44) et, par l'intermédiaire de moyens d'inversion (42, 43), aux électrodes de grille desdits deuxième et sixième transistors (46, 41).
